# EUROPÄISCHE PATENTSCHRIFT

(11) **EP 1 605 740 B1**
(45) Veröffentlichungstag und Bekanntmachung des Hinweises auf die Patenterteilung: **20.08.2008**
(21) Anmeldenummer: 05004345.4
(22) Anmeldetag: 28.02.2005
(51) Int. Cl.: H05K 7/14

(54) **Haltevorrichtung zur Festlegung eines Montagewinkels**
Holding device for defining a mounting angle
Dispositif de fixation pour definir un angle de montage

(30) Priorität: 16.03.2004 DE 102004012861
(43) Veröffentlichungstag der Anmeldung: 14.12.2005
(73) Patentinhaber: Fujitsu Siemens Computers GmbH, 80807 München (DE)
(72) Erfinder: Köhler, Friedrich, 86405 Meitingen (DE)
(74) Vertreter: Epping - Hermann - Fischer

(56) Entgegenhaltungen:
- US-A- 5 991 983
- US-A1- 2003 107 878

## Beschreibung

Die Erfindung betrifft eine Haltevorrichtung zur Festlegung eines Montagewinkels an einer Gehäusewandung eines Datenverarbeitungsgerätes, wobei für jeden Montagewinkel eine Klemmvorrichtung vorgesehen ist, welche dem Montagewinkel an der Gehäusewandung klemmend festlegt und wobei jede Klemmvorrichtung zumindest ein Federelement mit einen ersten und einen zweiten Schenkel aufweist und die Schenkel zueinander gegenüberliegend angeordnet sind.

Standardflachbaugruppen, insbesondere die in der Computertechnik eingesetzten Steckkarten, werden üblicherweise mit Hilfe von Montagewinkeln an entsprechend gestalteten Einbauplätzen montiert. In diesen Montagewinkeln ist jeweils wenigstens ein Steckverbinder befestigt, der die Verbindung der Steckkarte zu externen Anschlüssen herstellt. Die Gehäusewandung weist deshalb an den Einbauplätzen jeweils schlitzartige Aussparungen auf, die von dem jeweiligen Montagewinkel abgedeckt werden. Am Montagewinkel ist ferner ein rechtwinklig angesetzter Halteflansch vorgesehen, der sich an einer entsprechend abgewinkelten Stützfläche der Gehäusewandung anschmiegt und dort mittels einer Schraub- oder Klemmverbindung lösbar fixiert wird.

So ist beispielsweise aus DE 44 03 907 A1 eine Haltevorrichtung in Form einer alle einsteckbaren Flachbaugruppen bzw. deren Montagewinkel übergreifenden Klemmleiste bekannt, die im eingesetzten Zustand alle Steckkarten fixiert und im Freigabezustand alle Steckkarten freigibt, und die elastische Bereiche aufweist, die den einzelnen Steckkarten zugeordnet sind. Nachteilig dabei ist, dass unabhängig von der Zahl der belegten Einbauplätze stets eine alle Einbauplätze erfassende entsprechend breite Klemmleiste erforderlich ist und dass beim Nachrüsten oder Auswechseln die Befestigung für alle übrigen an sich nicht betroffene Flachbaugruppen zwischenzeitlich gelockert werden muss.

Weiterhin ist aus der EP 0 886 819 B1 eine Haltevorrichtung für die Montagewinkel von Standardflachbaugruppen bekannt, bei der jedem Halteflansch eine individuelle aus einem bügelartigen Federelement bestehende Klemmvorrichtung zugeordnet ist. Dabei stützt sich das Federelement der jeweiligen Klemmvorrichtung mit den Bügelenden an der Gehäusewandung ab und ist zwischen dem Halteflansch des Montagewinkels und jeweils an der Gehäusewandung vorgesehenen Rastelement einschnappbar. Nachteilig ist dabei, dass bei nachlassender Federkraft die Haltekraft des bügelartigen Federelementes nachlässt, und damit die Zuverlässigkeit der Haltevorrichtung vermindert ist.

Aus der Druckschrift US 2003/107878 A1 ist eine andere Form der Festlegung eines Montagewinkels, an einer Gehäusewandung gezeigt, bei der ein um eine Achse drehbar gelagertes Verriegelungselement den Montagewinkel an der Gehäusewandung festlegt. Zusätzlich ist zur Sicherung des Verriegelungselements dabei ein Federelement mit einem ersten und einem zweiten Schenkel vorgesehen. Die Schenkel sind zueinander gegenüber angeordnet sind. Lässt die Federkraft nach, so kann sich das Verriegelungselement lösen.

Es ist daher die Aufgabe der vorliegenden Erfindung, die Zuverlässigkeit des Halteelements zu verbessern und die Haltekraft von der Federkraft unabhängig zu gestalten.

Die Lösung dieser Aufgabe ergibt sich erfindungsgemäß durch die Merkmale des Anspruchs 1. Vorteilhafte Weiterbildungen der Erfindungen sind in den Unteransprüchen angegeben.

Dabei ist eine Haltevorrichtung zur Festlegung eines Montagewinkels an einer Gehäusewandung eines Datenverarbeitungsgerätes vorgeschlagen, wobei für jeden Montagewinkel eine Klemmvorrichtung vorgesehen ist, welche dem Montagewinkel an der Gehäusewandung klemmend festlegt. Jede Klemmvorrichtung weist dabei zumindest ein Federelement mit einen ersten und einen zweiten Schenkel auf und die Schenkel sind zueinander gegenüberliegend angeordnet. Die Zuverlässigkeit des Halteelements wird dadurch verbessert, dass zumindest ein Verriegelungselement an jeder Klemmvorrichtung vorgesehen ist, welches im Verriegelungszustand das Federelement in einer klemmenden Stellung dadurch festlegt, dass es im verriegelten Zustand zwischen die beiden Schenkel eingespreizt ist.

Die Haltevorrichtung ist dabei auch vorzugsweise für die Montagewinkel von Standardflachbaugruppen vorgeschlagen, die den Montagewinkel an Einbauplätzen von schlitzartigen Aussparungen in einer Gehäusewandung eines Datenverarbeitungsgerätes lösbar befestigt. Dabei ist der an einer abgewinkelten Stützfläche der Gehäusewandung anliegende, entsprechend abgewinkelte Halteflansch des Montagewinkels, mittels einer Klemmvorrichtung fixierbar. Diese Klemmvorrichtung zeigt ein U-förmig ausgebildetes bügelartiges Federelement, das sich mit den Bügelenden an der Gehäusewandung abstützt, und zwischen dem Halteflansch des Montagewinkels und jeweils an der Gehäusewandung vorgesehenem Rastelement einschnappbar ist. Dabei ist das bügelartige Federelement U-förmig gebildet, und weist einen ersten und einen zweiten Schenkel auf, die gegenüberliegend voneinander angeordnet sind. Vorzeugswiese sind die beiden Schenkel parallel zueinander angeordnet. Ein Verriegelungselement, umfassend eine Achse, mit der das Verriegelungselement drehbar in einem Achslager an einem Schenkel des bügelartigen Federelements gelagert ist, und zumindest einen Riegel, der an der Achse radial angeordnet ist, dient zur Verriegelung des an sich elastisch ausgeprägten U-förmigen Bügelelementes. Der Riegel ist dabei zum Beispiel L-förmig ausgebildet, so dass er sich im verriegelten Zustand zwischen die Enden der beiden Schenkel einspreizt. Damit ist das U-förmige bügelartige Federelement nicht mehr zusammendrückbar, da der Riegel dieser Bewegungsrichtung entgegenwirkt. Nach einem Öffnen des Riegels liegt der Riegel nicht mehr an beiden Schenkelenden an, und das bügelartige U-förmige Federelement lässt sich dann entgegen der Federkraft zusammendrücken.

In einer vorteilhaften Ausführungsform ist die Haltevorrichtung um eine Grundplatte erweitert, die mit dem ersten Schenkel des U-förmigen Federelementes kraft- und formschlüssig verbunden ist. Diese Grundplatte wiederum weist einen Haltewinkel auf, der den Montagewinkel an seinem abgewinkelten Halteflansch formschlüssig umgibt. Vorteilhaft verbessern sind dadurch die Fixierungs- und Halteeigenschaften des Halteelements gegenüber dem Montagewinkel.

In einer weiteren vorteilhaften Ausführungsform ist der zweite Schenkel des U-förmigen Federelementes mit einer Rastnase abgeschlossen. Diese Rastnase ist gegenüber dem Federelement so abgewinkelt, dass die Rastnase unter dem Rastelement, das an der Gehäusewand angeordnet ist, einführbar ist. Vorzugsweise ist die Rastnase mit in etwa 90° Winkelgraden gegenüber den zweiten Schenkel abgewinkelt. Damit ergibt sich eine formschlüssige und kraftschlüssige Verbindung des Halteelements mit der Gehäusewand. Bei verriegeltem Riegel ist dann die Rastnase unter dem Rastelement nicht mehr gewaltfrei zu entfernen. Um das Halteelement zu lösen, muss der Riegel gelöst und dann das Halteelement an seinem U-förmigen Federelement entgegen der Federkraft zusammengedrückt werden. Dann kann die Rastnase unter dem Rastelement herausgezogen und das Halteelement entfernt werden.

Weiter ist es vorteilhaft, den Riegel mit einem Bedienelement auszustatten, das in Form einer länglichen Stange mit dem Riegel verbunden ist. Das Bedienelement kann dabei drehbar oder fest mit dem Riegel verbunden sein. Im wesentlichen ist das abhängig davon, an welcher Stelle das Bedienelement mit dem Riegel verbunden ist. Greift das Bedienelement an den äußeren Enden des Riegels, und nicht an seiner Drehachse an, so genügt es, das Bedienelement zum Beispiel fest mit dem Riegel zu verbinden, um so eine zusätzliche Hebelkraft zur Bedienung des Riegels zu erwirken. Ist das Bedienelement an dieser Stelle drehbar mit dem Riegel verbunden, kann es lediglich zum Ziehen oder Drücken des Riegels in die gewünschte Position verwendet werden. Eine Hebelwirkung gegenüber dem Riegel ist dann nicht erreichbar. Ist das Bedienelement an der Drehachse des Riegels angeordnet, so muss es dort selbstverständlich fest und kraftschlüssig verbunden sein. Vorteilhaft ergibt sich dabei eine Hebelwirkung bei der Bedienung des Riegels.

In einer vorteilhaften Ausführungsform ist die Klemmvorrichtung, vorzugsweise das U-förmige Bügelelement aus elastischem Kunststoff gebildet. Vorzugsweise ist in diesem Fall der Rest der Haltevorrichtung ist aus festem bzw. weniger elastischem Kunststoff gebildet, da dort keine elastischen Eigenschaften erwünscht und benötigt werden.

In einer weiteren vorteilhaften Ausführungsform weist die Klemmvorrichtung an dem Halteflansch einen Zentrierdorn auf, der durch eine U-förmige Kerbe im Montagewinkel eine lochartige Aussparung der Stützfläche der Gehäusewandung eintaucht.

In einer weiteren vorteilhaften Ausführungsform ist an der dem Halteflansch abgewandten Seite des bügelartigen U-förmigen Federelementes ein nasenartig vorspringendes Griffelement vorgesehen, das die Bedienung der Klemmvorrichtung und insbesondere das Zusammendrücken des Federelements wesentlich erleichtert.

Im Folgenden ist die Erfindung anhand eines Ausführungsbeispiels mit zwei Figuren näher erläutert.

### Es zeigt die

- Figur 1: eine Klemmvorrichtung im verriegelten Zustand
- Figur 2: eine Klemmvorrichtung im offenen Zustand.

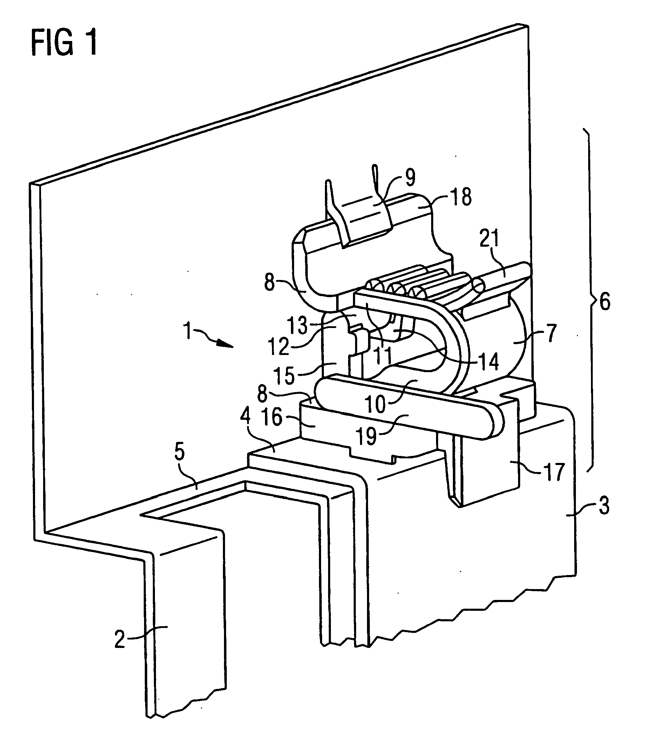

Die Figur 1 zeigt einen Ausschnitt einer Gehäuserückwand 1 eines PC-Gehäuses, das im Bereich zweier Einbauplätze für Steckkarten eine etwa rechteckförmige Einbuchtung aufweist. An den parallel zueinander angeordneten Einbauplätzen in Form schlitzartiger Aussparungen sind jeweils L-förmige Montagewinkel 3 einer Steckkarte bzw. bei nicht belegten Einbauplätzen zu diesen Montagewinkeln baugleiche Abdeckwinkel befestigbar. Die Befestigung des Montagewinkels 3 bzw. des baugleichen Abdeckwinkels erfolgt an dessen rechtwinklig abgebogenem Halteflansch 4, der sich an einer durch die Einbuchtung 2 gebildeten Stützfläche 5 der Gehäusewandung 1 anschmiegt. Zur Befestigung des L-förmigen Montagewinkels ist eine Klemmvorrichtung 6 vorgesehen, die ein U-förmiges bügelartiges Federelement 7 enthält, wobei sich dieses Federelement 7 mit den Bügelenden 8 an die Gehäusewandung 1 abstützt und zwischen dem Halteflansch 4 einerseits und einem an der Gehäusewandung 1 vorgesehenen Rastelement 9 andererseits einschnappbar ist. Als Rastelement 9 ist vorzugsweise eine aus der Gehäusewandung 1 herausgerissene Blechlasche vorgesehen.

Das U-förmige bügelartige Federelement 7 ist gebildet aus einem ersten Schenkel 10 und einem zweiten Schenkel 11, wobei diese beispielsweise aus Kunststoff insbesondere federndem elastischem Kunststoff bestehen. An der Innenseite der beiden Schenkel des U-förmigen bügelartigen Federelements ist ein Verriegelungselement 12 angeordnet, das mit einer Achse 13 in einem Achslager drehbar an einem der Schenkel angeordnet ist. Das Verriegelungselement 12 ist vorzugsweise L-förmig ausgebildet und weist ein radial angeordnetes Riegelelement 15 auf, das in seinem verriegelten Zustand ein Zueinanderdrücken der beiden Schenkel 10 und 11 verhindert, indem es sich zwischen die beiden Schenkelenden 8 einspreizt. Je nach Ausführungsform wird dabei nicht nur der Abstand der beiden Schenkelenden auf ein Minimum fixiert, sondern gegebenenfalls auch um einen vorbestimmten Wert erweitert. Damit ist das Schenkelende 8 des zweiten Schenkels 11 gegen das Rastelement 9 gedrückt, so dass eine kraftschlüssige Verbindung zwischen Schenkelende 8 und Rastelement 9 hergestellt ist.

Die Klemmvorrichtung weist weiterhin eine Grundplatte 16 auf, die an ihrem zur Innenseite des Datenverarbeitungsgerätes hin gerichteten Ende eine abfallende, um die Winkelung des L-förmigen Montagewinkels angeschmiegte Haltenase 17 aufweist, wobei zusätzliche Haltekräfte gegenüber dem Montagewinkel 3 und zusätzliche Fixierungseigenschaften gegenüber dem Montagewinkel 3 realisierbar sind.

In einer bevorzugten Ausführungsform ist das Schenkelende 8 des zweiten Schenkels 11 um eine abgewinkelte Rastnase 18 erweitert. Vorzugsweise weist diese eine in Richtung des Rastelementes gerichtete keilförmige Ausprägung auf. Damit ist sie unter das Rastelement 9 einschiebbar. Die Abwinkelung der Rastnase 18 beträgt dabei vorzugsweise 90° Winkelgrade gegenüber den zweiten Schenkel 11. Die Verbindung wird dadurch zu einer form- und kraftschlüssigen Verbindung vorteilhaft erweitert und ist gegenüber einer reinen kraftschlüssigen Verbindung deutlich zuverlässiger in ihrer dauerhaften Beständigkeit. Durch das Riegelelement 15 wird weiterhin zuverlässig verhindert, dass auch bei Materialermüdung des Federelementes 7 die Haltekräfte an dem Rastelement 18 nachlassen. Das Riegelelement 15 ist durch ein stangenförmiges Bedienelement 19 so erweitert, dass die Bedienung des Riegelelementes 15 bzw. des L-förmigen Riegels 12 auch von einem entfernten Punkt ausgeführt werden kann und dabei je nach Befestigungsart des Bedienelements 19 an dem Riegelelement 15 eine Hebelwirkung zusätzlich auf das Riegelelement ausgeübt werden kann. Abhängig ist dies davon, ob die Verbindung des Bedienelementes 19 mit dem Riegelelement 15 eine feste oder eine drehbare Verbindung ist.

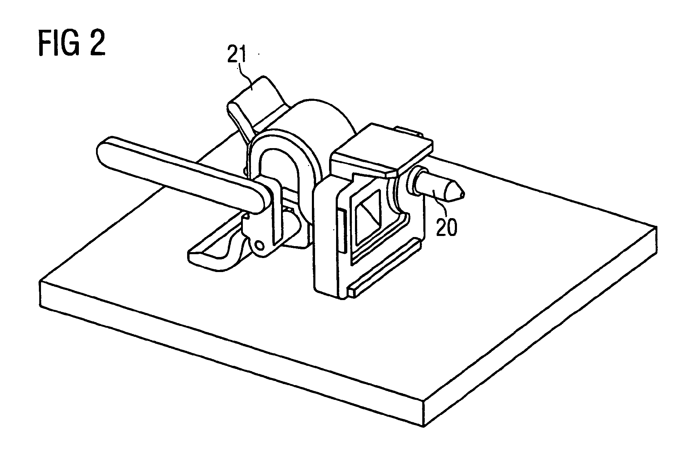

Figur 2 zeigt die Klemmvorrichtung aus Figur 1 aus einer anderen Blickrichtung, wobei an der dem Halteflansch 4 zugewandten Seite der Grundplatte 16 der Klemmvorrichtung 6 ein Zentrierdorn 20 angeordnet ist. Dieser Zentrierdorn 20 führt im montierten Zustand durch eine U-förmige Kerbe im Montagewinkel und taucht in eine lochartige Aussparung in der Stützfläche 5 der Gehäusewandung ein, wodurch der Montagewinkel über die Klemmung hinaus zusätzlich fixiert wird. Die U-förmige Aussparung des Montagewinkels ist in Figur 1 aufgrund der perspektivischen Darstellung nicht einsehbar. Zusätzlich dient ein nasenartiger Vorsprung als Griffelement 21, der an einem insbesondere an dem zweiten Schenkel des U-förmigen Federelementes 7 angeordnet ist.

Die Figur 1 zeigt die Klemmvorrichtung in einem verriegelten und die Figur 2 zeigt die Klemmvorrichtung in einem entriegelten Zustand. Wobei das Riegelelement 15 im entriegelten Zustand nicht zwischen den beiden Schenkelenden 8 des U-förmigen Federelementes 7 eingespreizt ist.

### Bezugszeichenliste

- 1: Gehäusewandung eines Datenverarbeitungsgeräts
- 2: Einbuchtung
- 3: Montagewinkel
- 4: Halteflansch
- 5: Stützfläche
- 6: Klemmvorrichtung
- 7: Federelement
- 8: Bügelenden
- 9: Rastelement
- 10: erster Schenkel
- 11: zweiter Schenkel
- 12: Verriegelungselement
- 13: Achse
- 14: Achslager
- 15: Riegel
- 16: Grundplatte
- 17: Haltewinkel
- 18: Rastnase
- 19: Bedienungselement
- 20: Zentrierdorn
- 21: Griffelement

## Patentansprüche

1. Haltevorrichtung zur Festlegung eines Montagewinkels (3) an einer Gehäusewandung (1) eines Datenverarbeitungsgerätes, wobei für jeden Montagewinkel (3) eine Klemmvorrichtung (6) vorgesehen ist, welche den Montagewinkel (3) an der Gehäusewandung (1) klemmend festlegt, wobei jede Klemmvorrichtung (6) zumindest ein Federelement mit einem ersten und einem zweiten Schenkel aufweist und die Schenkel zueinander gegenüberliegend angeordnet sind, **dadurch gekennzeichnet, dass**
zumindest ein Verriegelungselement (12) an jeder Klemmvorrichtung vorgesehen ist, welches im Verriegelungszustand das Federelement (7) in einer klemmenden Stellung **dadurch** festlegt, dass es im verriegelten Zustand zwischen die beiden Schenkel eingespreizt ist.

2. Haltevorrichtung nach Patentanspruch 1,
**dadurch gekennzeichnet, dass**
der Montagewinkel (3) an Einbauplätzen in Form schlitzartiger Aussparungen in einer Gehäusewandung angeordnet ist.

3. Haltevorrichtung nach einem der vorhergehenden Patenansprüche,
**dadurch gekennzeichnet, dass**
an einer abgewinkelten Stützfläche (5) der Gehäusewandung (1) ein entsprechend abgewinkelter Halteflansch (4) des Montagewinkels (3) mittels der Klemmvorrichtung (6) fixierbar ist.

4. Haltevorrichtung nach einem der vorhergehenden Patenansprüche,
**dadurch gekennzeichnet, dass**
das Federelement (7) eine bügelartige Form aufweist.

5. Haltevorrichtung nach einem der vorhergehenden Patenansprüche,
**dadurch gekennzeichnet, dass**
sich das Federelement (7) der jeweiligen Klemmvorrichtung (6) mit den Bügelenden (8) an der Gehäusewandung (1) abstützt.

6. Haltevorrichtung nach einem der vorhergehenden Patenansprüche,
**dadurch gekennzeichnet, dass**
das Federelement (7) zwischen dem Halteflansch (4) des Montagewinkels (3) an jeweils zumindest einem an der Gehäusewandung (1) vorgesehenem Rastelement (9) einschnappbar ist.

7. Haltevorrichtung nach einem der vorhergehenden Patenansprüche,
**dadurch gekennzeichnet, dass**
das bügelartige Federelement (7) U-förmig gebildet ist, und einen ersten Schenkel (10) und einen zweiten Schenkel (11) aufweist, die gegenüberliegend angeordnet sind.

8. Haltevorrichtung nach einem der vorhergehenden Patenansprüche,
**dadurch gekennzeichnet, dass**
das Verriegelungselement (12), zumindest
- eine Achse (13), umfasst mit der das Verriegelungselement (12) drehbar in einem Achslager an einem Schenkel des bügelartigen Federelements (7) gelagert ist und
- zumindest einen Riegel (15), der radial an der Achse (13) angeordnet ist.

9. Haltevorrichtung nach einem der vorhergehenden Patenansprüche,
**dadurch gekennzeichnet, dass**
das Achslager (14) an einer Innenseite eines der Schenkel (10, 11) angeordnet ist.

10. Haltevorrichtung nach einem der vorhergehenden Patentansprüche,
**dadurch gekennzeichnet, dass**
der Riegel (15) zwei Hauptstellungen, ver- und entriegelt, aufweist, wobei die verriegelte Stellung **dadurch** gebildet ist, dass der Riegel (15) an den beiden Schenkeln bündig anliegt, und die entriegelte Stellung **dadurch** gebildet ist, dass der Riegel (15) an nur maximal einem der beiden Schenkel anliegt.

11. Haltevorrichtung nach einem der vorhergehenden Patentansprüche,
**dadurch gekennzeichnet, dass**
die Haltevorrichtung eine Grundplatte (16) aufweist, die mit dem ersten Schenkel (10) kraft- und formschlüssig verbunden ist, und die einen Haltewinkel (17) aufweist, der den Montagewinkel (3) an seinem abgewinkelten Halteflansch (4) formschlüssig umgibt.

12. Haltevorrichtung nach einem der vorhergehenden Patentansprüche,
**dadurch gekennzeichnet, dass**
der zweite Schenkel (11) mit einer Rastnase (18) abgeschlossen ist, die so abgewinkelt ist, dass sie unter das Rastelement (9) einführbar ist.

13. Haltevorrichtung nach einem der vorhergehenden Patentansprüche,
**dadurch gekennzeichnet, dass**
der Riegel mit einem Bedienungselement (19) fest oder drehbar verbunden ist.

14. Haltevorrichtung nach einem der vorhergehenden Patentansprüche,
**dadurch gekennzeichnet, dass**
das Federelement (7) aus elastischem Kunststoff besteht.

15. Haltevorrichtung nach einem der vorhergehenden Patentansprüche,
**dadurch gekennzeichnet, dass**
die Klemmvorrichtung (6) aus elastischem Kunststoff besteht.

16. Haltevorrichtung nach einem der vorhergehenden Patentansprüche,
**dadurch gekennzeichnet, dass**
die Klemmvorrichtung (6) an der dem Halteflansch (4) zugewandten Seite einen Zentrierdorn (20) aufweist, der durch eine U-förmige Kerbe im Montagewinkel (3) in eine lochartige Aussparung in der Stützfläche (5) der Gehäusewandung (1) eintaucht.

17. Haltevorrichtung nach einem der vorhergehenden Patentansprüche,
**dadurch gekennzeichnet, dass**
die dem Halteflansch (4) zugewandte Seite der Klemmvorrichtung (6) als zum Halteflansch (4) planparallele Fläche ausgebildet ist.

18. Haltevorrichtung nach einem der vorhergehenden Patentansprüche,
**dadurch gekennzeichnet, dass**
an dem dem Halteflansch (4) abgewandten Bereich des bügelartigen Federelementes (7) ein nasenartig vorspringendes Griffelement (21) vorgesehen ist.

19. Haltevorrichtung nach einem der vorhergehenden Ansprüche,
**dadurch gekennzeichnet, dass**
der Abstand der Schenkelenden (8) im verriegelten Zustand größer ist als im entriegelten Zustand.

## Claims

1. Holding apparatus for fixing a mounting bracket (3) on a housing wall (1) of a data processing device, a clamping apparatus (6) being provided for each mounting bracket (3), which clamping apparatus fixes the mounting bracket (3) on the housing wall (1) in clamping fashion, each clamping apparatus (6) having at least one spring element with a first and a second limb, and the limbs being arranged opposite one another, **characterized in that** at least one locking element (12) is provided on each clamping apparatus and, in the locking state, fixes the spring element (7) in a clamping position by virtue of the fact that, in the locked state, it spreads in between the two limbs.

2. Holding apparatus according to Patent Claim 1, **characterized in that** the mounting bracket (3) is arranged at installation locations in the form of slot-like cutouts in a housing wall.

3. Holding apparatus according to one of the preceding patent claims, **characterized in that** a correspondingly bent-back holding flange (4) of the mounting bracket (3) is capable of being fixed by means of the clamping apparatus (6) at a bent-back supporting surface (5) of the housing wall (1).

4. Holding apparatus according to one of the preceding patent claims, **characterized in that** the spring element (7) has a bow-like shape.

5. Holding apparatus according to one of the preceding patent claims, **characterized in that** the spring element (7) of the respective clamping apparatus (6) is supported with the bow ends (8) on the housing wall (1).

6. Holding apparatus according to one of the preceding patent claims, **characterized in that** the spring element (7) is capable of being snapped in between the holding flange (4) of the mounting bracket (3) on in each case at least one latching element (9), which is provided on the housing wall (1).

7. Holding apparatus according to one of the preceding patent claims, **characterized in that** the bow-like spring element (7) is in the form of a U and has a first limb (10) and a second limb (11), which are arranged opposite one another.

8. Holding apparatus according to one of the preceding patent claims, **characterized in that** the locking element (12) comprises
- at least one spindle (13), with which the locking element (12) is mounted rotatably in a spindle bearing on a limb of the bow-like spring element (7), and
- at least one locking bar (15), which is arranged radially on the spindle (13).

9. Holding apparatus according to one of the preceding patent claims, **characterized in that** the spindle bearing (14) is arranged on an inner side of one of the limbs (10, 11).

10. Holding apparatus according to one of the preceding patent claims, **characterized in that** the locking bar (15) has two main positions, locked and unlocked, the locked position being formed by virtue of the locking bar (15) bearing flush against the two limbs, and the unlocked position being formed by virtue of the locking bar (15) bearing against only a maximum of one of the two limbs.

11. Holding apparatus according to one of the preceding patent claims, **characterized in that** the holding apparatus has a base plate (16), which is connected in a force-fitting and form-fitting manner to the first limb (10), and which has a holding bracket (17), which surrounds the mounting bracket (3) at its bent-back holding flange (4) in a form-fitting manner.

12. Holding apparatus according to one of the preceding patent claims, **characterized in that** the second limb (11) is terminated by a latching tab (18), which is bent back in such a way that it is capable of being inserted below the latching element (9).

13. Holding apparatus according to one of the preceding patent claims, **characterized in that** the locking bar is fixedly or rotatably connected to an operating element (19).

14. Holding apparatus according to one of the preceding patent claims, **characterized in that** the spring element (7) is made from elastic plastic.

15. Holding apparatus according to one of the preceding patent claims, **characterized in that** the clamping apparatus (6) is made from elastic plastic.

16. Holding apparatus according to one of the preceding patent claims, **characterized in that** the clamping apparatus (6) has a centring mandrel (20) on the side facing the holding flange (4), which centring mandrel passes through a U-shaped notch in the mounting bracket (3) into a hole-like cutout in the supporting surface (5) of the housing wall (1).

17. Holding apparatus according to one of the preceding patent claims, **characterized in that that** side of the clamping apparatus (6) which faces the holding flange (4) is in the form of a face which is planar-parallel with respect to the holding flange (4).

18. Holding apparatus according to one of the preceding patent claims, **characterized in that** a grip element (21), which protrudes in the form of a tab, is provided on that region of the bow-like spring element (7) which is remote from the holding flange (4).

19. Holding apparatus according to one of the preceding claims, **characterized in that** the distance between the limb ends (8) in the locked state is greater than in the unlocked state.

## Revendications

1. Dispositif de fixation pour fixer un coin de montage (3) sur une paroi de boîtier (1) d'un appareil de traitement des données, dans lequel, pour chaque coin de montage (3), on prévoit un dispositif de serrage (6) qui fixe par serrage le coin de montage (3) sur la paroi de boîtier (1), chaque dispositif de serrage (6) présentant au moins un élément de ressort avec une première et une deuxième branche et les branches étant disposées en face l'une de l'autre,
**caractérisé en ce qu'**
au moins un élément de verrouillage (12) est prévu sur chaque dispositif de serrage, et fixe dans l'état de verrouillage l'élément de ressort (7) dans une position de serrage en étant coincé entre les deux branches dans l'état de verrouillage.

2. Dispositif de fixation selon la revendication 1,
**caractérisé en ce que**
le coin de montage (3) est disposé dans des emplacements d'installation en forme d'évidements de type fente dans une paroi de boîtier.

3. Dispositif de fixation selon l'une quelconque des revendications précédentes,
**caractérisé en ce qu'**
au niveau d'une surface de support coudée (5) de la paroi de boîtier (1), on peut fixer une bride de fixation (4) coudée de manière correspondante du coin de montage (3) au moyen du dispositif de serrage (6).

4. Dispositif de fixation selon l'une quelconque des revendications précédentes,
**caractérisé en ce que**
l'élément de ressort (7) présente une forme en arceau.

5. Dispositif de fixation selon l'une quelconque des revendications précédentes,
**caractérisé en ce que**
l'élément de ressort (7) du dispositif de serrage respectif (6) s'appuie avec les extrémités d'arceau (8) contre la paroi de boîtier (1).

6. Dispositif de fixation selon l'une quelconque des revendications précédentes,
**caractérisé en ce que**
l'élément de ressort (7) peut être encliqueté entre la bride de fixation (4) du coude de montage (3) sur au moins à chaque fois un élément d'encliquetage (9) prévu sur la paroi de boîtier (1).

7. Dispositif de fixation selon l'une quelconque des revendications précédentes,
**caractérisé en ce que**
l'élément de ressort (7) en forme d'arceau est réalisé en forme de U, et présente une première branche (10) et une deuxième branche (11), qui sont disposées l'une en face de l'autre.

8. Dispositif de fixation selon l'une quelconque des revendications précédentes,
**caractérisé en ce que**
l'élément de verrouillage (12) comprend au moins
- un axe (13) avec lequel l'élément de verrouillage (12) est monté à rotation dans un palier d'axe sur une branche de l'élément de ressort (7) en forme d'arceau et
- au moins un verrou (15) qui est disposé radialement sur l'axe (13).

9. Dispositif de fixation selon l'une quelconque des revendications précédentes,
**caractérisé en ce que**
le palier d'axe (14) est disposé sur un côté intérieur de l'une des branches (10, 11).

10. Dispositif de fixation selon l'une quelconque des revendications précédentes,
**caractérisé en ce que**
le verrou (15) présente deux positions principales, verrouillée et déverrouillée, la position verrouillée étant obtenue par le fait que le verrou (15) s'applique en affleurement contre les deux branches, et la position déverrouillée étant obtenue par le fait que le verrou (15) ne s'applique qu'au maximum contre l'une des deux branches.

11. Dispositif de fixation selon l'une quelconque des revendications précédentes,
**caractérisé en ce que**
le dispositif de fixation présente une plaque de base (16), qui est connectée à la première branche (10) par engagement par force et par coopération de forme, et qui présente un coin de fixation (17) qui entoure par engagement par coopération de forme le coin de montage (3) au niveau de sa bride de fixation coudée (4).

12. Dispositif de fixation selon l'une quelconque des revendications précédentes,
**caractérisé en ce que**
la deuxième branche (11) se termine par un nez d'encliquetage (18) qui est coudé de telle sorte qu'il puisse être introduit sous l'élément d'encliquetage (9).

13. Dispositif de fixation selon l'une quelconque des revendications précédentes,
**caractérisé en ce que**
le verrou est connecté fixement ou à rotation à un élément de commande (19).

14. Dispositif de fixation selon l'une quelconque des revendications précédentes,
**caractérisé en ce que**
l'élément de ressort (7) se compose de matière plastique élastique.

15. Dispositif de fixation selon l'une quelconque des revendications précédentes,
**caractérisé en ce que**
le dispositif de serrage (6) se compose de matière plastique élastique.

16. Dispositif de fixation selon l'une quelconque des revendications précédentes,
**caractérisé en ce que**
le dispositif de serrage (6) présente, du côté tourné vers la bride de fixation (4), un mandrin de centrage (20) qui plonge à travers une encoche en forme de U dans le coin de montage (3) dans un évidement en forme de trou dans la surface de support (5) de la paroi de boîtier (1).

17. Dispositif de fixation selon l'une quelconque des revendications précédentes,
**caractérisé en ce que**
le côté du dispositif de serrage (6) tourné vers la bride de fixation (4) est réalisé sous forme de surface à plan parallèle à la bride de fixation (4).

18. Dispositif de fixation selon l'une quelconque des revendications précédentes,
**caractérisé en ce que**
l'on prévoit au niveau de la région de l'élément de ressort (7) en forme d'arceau opposée à la bride de fixation (4) un élément de préhension (21) saillant en forme de nez.

19. Dispositif de fixation selon l'une quelconque des revendications précédentes,
**caractérisé en ce que**
la distance entre les extrémités des branches (8) dans l'état verrouillé est supérieure à la distance dans l'état déverrouillé.
